# FASCICULE DE BREVET EUROPEEN

(11) **EP 3 186 894 B1**
(45) Date de publication et mention de la délivrance du brevet: **06.07.2022**
(21) Numéro de dépôt: 15754211.9
(22) Date de dépôt: 25.08.2015
(51) Int. Cl.: H04B 1/04, H03H 7/40

(54) **DISPOSITIF COMPRENANT UN POSTE DE RADIOCOMMUNICATION**
VORRICHTUNG MIT EINEM FUNKKOMMUNIKATIONSENDGERÄT
DEVICE COMPRISING A RADIO COMMUNICATION TERMINAL

(30) Priorité: 27.08.2014 FR 1401907
(43) Date de publication de la demande: 05.07.2017
(73) Titulaire: Thales, 92400 Courbevoie (FR)
(72) Inventeur: DEMENITROUX, Wilfried Alain, F-49309 Cholet (FR); SABOUREAU, Cedrick, F-49309 Cholet (FR); MAILLOUX, Pierre-Yves, F-49309 Cholet (FR); GERFAULT, Bertrand, F-49309 Cholet (FR)
(74) Mandataire: Lavoix
(86) Numéro de dépôt international: PCT/EP2015/069466
(87) Numéro de publication internationale: WO 2016/030387

(56) Documents cités:
- EP-A2- 2 037 576
- WO-A1-2015/191301
- US-A- 4 704 573
- US-A- 5 564 086
- US-A1- 2007 135 062
- US-A1- 2009 046 030

## Description

La présente invention concerne un poste de radiocommunication et un dispositif comportant un tel poste de radiocommunication. La présente invention se rapporte également au procédé d'adaptation d'impédance associé.

Un poste de radiocommunication comporte usuellement un amplificateur de puissance et une antenne. Dans de multiples applications, les antennes sont fortement désadaptées par rapport à l'amplificateur de puissance, ceci entraînant un sous-régime en fonctionnement. Notamment, la puissance transmise, la consommation et la linéarité sont fortement dégradées. Dans certains cas, la sortie de l'amplificateur de puissance casse.

Pour remédier aux problèmes précédents, il a été proposé des boitiers d'adaptation d'antenne.

D'autres systèmes sont connus des documents EP 2 037 576 A2, US 2007/135062 A1, US 2009/046030 A1, US 5 564 086 A et US 4 704 573 A.

Toutefois, de tels boîtiers entraînent des pertes de puissance et donc une dégradation de la sensibilité de la partie réception, et une forte perte de rendement en émission. Cela génère notamment une surconsommation et un encombrement gênant pour certaines applications.

Il existe donc un besoin pour un poste de radiocommunication présentant un meilleur rendement.

Pour cela, il est proposé un poste de radiocommunication comprenant une antenne présentant une impédance, un capteur de mesure d'impédance propre à mesurer l'impédance de l'antenne pour obtenir une impédance mesurée, un amplificateur, un filtre relié à l'antenne et à l'amplificateur, le filtre ayant une impédance variable, et un organe de contrôle de l'impédance du filtre, l'organe étant propre à contrôler l'impédance du filtre en fonction de l'impédance mesurée. Le filtre est un filtre propre à assurer une fonction de filtrage d'harmoniques entre l'amplificateur et l'antenne. Le filtre est un circuit LC, le circuit LC comportant une entrée et une sortie, un élément générant une impédance inductive reliant l'entrée à la sortie et un premier condensateur reliant l'entrée à la masse et un deuxième condensateur reliant la sortie à la masse, le premier condensateur comportant une pluralité de condensateurs de valeur fixe reliés chacun à un interrupteur commandé respectif, le deuxième condensateur comportant une pluralité de condensateurs de valeur fixe reliés chacun à un interrupteur commandé respectif. L'organe de commande est également propre à commander chaque interrupteur. Le poste comporte, en outre un capteur de mesure de puissance, le capteur de mesure de puissance mesurant la puissance réfléchie par le filtre pour obtenir une puissance réfléchie mesurée, l'organe de contrôle étant propre à contrôler l'impédance du filtre également en fonction de la puissance réfléchie mesurée.

Suivant des modes de réalisation particuliers, le poste de radiocommunication comprend une ou plusieurs des caractéristiques suivantes, prise(s) isolément ou suivant toute combinaison techniquement possible :
- l'organe de contrôle est propre à contrôler l'impédance du filtre pour que l'impédance du filtre soit égale à l'impédance conjuguée de l'impédance mesurée à 10% près du module de l'impédance mesurée.
- l'organe de contrôle est propre à contrôler l'impédance du filtre à intervalle de temps régulier.

Il est aussi proposé un dispositif, notamment téléphone portable, comportant un poste tel que précédemment décrit.

Il est également proposé un procédé d'adaptation d'impédance dans un poste de radiocommunication comprenant une antenne présentant une impédance, un capteur de mesure d'impédance, un amplificateur, un filtre relié à l'antenne et à l'amplificateur, le filtre ayant une impédance variable, et un organe de contrôle de l'impédance du filtre. Le procédé d'adaptation comporte les étapes de mesure de l'impédance de l'antenne par le capteur de mesure d'impédance pour obtenir une impédance mesurée, et de contrôle de l'impédance du filtre en fonction de l'impédance mesurée. Le filtre est un filtre propre à assurer une fonction de filtrage d'harmoniques entre l'amplificateur et l'antenne. Le filtre est un circuit LC, le circuit LC comportant une entrée et une sortie, un élément générant une impédance inductive reliant l'entrée à la sortie et un premier condensateur reliant l'entrée à la masse et un deuxième condensateur reliant la sortie à la masse, le premier condensateur comportant une pluralité de condensateurs de valeur fixe reliés chacun à un interrupteur commandé respectif, le deuxième condensateur comportant une pluralité de condensateurs de valeur fixe reliés chacun à un interrupteur commandé respectif. L'étape de contrôle de l'impédance du filtre comportant la commande de chaque interrupteur.

Le poste comporte, en outre un capteur de mesure de puissance, le capteur de mesure de puissance mesurant la puissance réfléchie par le filtre pour obtenir une puissance réfléchie mesurée. L'étape de contrôle de l'impédance du filtre est effectuée également en fonction de la puissance réfléchie mesurée.

D'autres caractéristiques et avantages de l'invention apparaîtront à la lecture de la description qui suit de modes de réalisation de l'invention, donnée à titre d'exemple uniquement et en référence aux dessins qui sont :
- figure 1, une représentation schématique d'un exemple de poste de radiocommunication,
- figure 2, un schéma d'un ordinogramme illustrant un exemple de mise en oeuvre d'un procédé d'adaptation d'impédance, et
- figure 3, une représentation schématique d'un autre exemple de poste de radiocommunication.

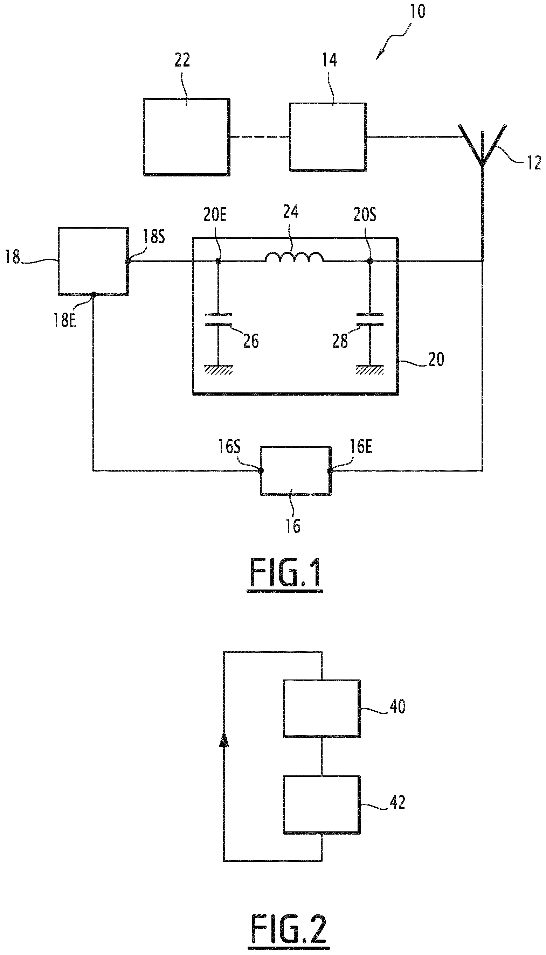

Un poste de radiocommunication 10 est représenté schématiquement à la figure 1.

Un poste de radiocommunication 10 est un poste propre à émettre des radiocommunications, à recevoir des radiocommunications et à traiter les signaux issus des radiocommunications émises ou reçues.

Une radiocommunication est une télécommunication effectuée dans l'espace au moyen d'ondes électromagnétiques. Ces ondes constituent une propagation d'énergie se manifestant sous la forme d'un champ électrique couplé à un champ magnétique. L'information est transportée grâce à une modulation constante des propriétés de l'onde, soit son amplitude, sa fréquence, sa phase ou, entre autres, par la largeur d'une impulsion.

Le poste de radiocommunication 10 comporte une antenne 12, un capteur de mesure d'impédance 14, une unité de traitement 16, un amplificateur 18, un filtre 20 et un organe de contrôle 22 de l'impédance du filtre 20.

L'antenne 12 est une antenne radioélectrique est un dispositif propre à recevoir et/ou émettre des ondes radio.

L'antenne 12 est, de préférence, une antenne large bande couvrant quelques octaves (quelques MHz à quelques centaines de MHz).

L'antenne 12 présente une impédance. Par définition, l'impédance électrique mesure l'opposition d'un circuit électrique au passage d'un courant alternatif sinusoïdal. La définition d'impédance est une généralisation de la loi d'Ohm dans l'étude des circuits en courant alternatif. L'impédance d'un dipôle linéaire passif de bornes A et B est définie en régime sinusoïdal de courant et de tension par le quotient du nombre complexe image du phaseur, représentant la tension entre les bornes, par le nombre complexe image du phaseur, représentant le courant électrique à travers le dipôle.

Le capteur de mesure d'impédance 14 est propre à mesurer l'impédance de l'antenne 12.

Le capteur de mesure d'impédance 14 est ainsi propre à délivrer un signal proportionnel à l'impédance de l'antenne 12. Le signal délivré par le capteur de mesure est généralement un signal électrique.

De préférence, le capteur de mesure d'impédance 14 est propre à mesurer l'impédance de l'antenne 12 à la fois en amplitude et en phase.

Selon l'exemple de la figure 1, le capteur de mesure d'impédance 14 comporte un coupleur mesurant le module de l'impédance de l'antenne 12 et un détecteur de phase mesurant la phase de l'impédance de l'antenne 12.

Le capteur de mesure d'impédance 14 est en liaison avec l'organe de contrôle 22 ainsi que le montrent les traits en pointillés sur la figure 1. Les traits en pointillés indiquent que le signal délivré par le capteur de mesure d'impédance 14 est transmis à l'organe de contrôle 22.

L'unité de traitement 16 est propre à traiter les signaux issus des radiocommunications émises ou reçues.

Dans l'exemple présenté sur la figure 1, l'unité de traitement 16 comporte une entrée 16E et une sortie 16S.

Dans le cas de l'émission, l'unité de traitement 16 est propre à générer des signaux à émettre par l'antenne 12, les signaux étant émis sur la sortie 16S de l'unité de traitement 16.

Pour la réception, l'unité de traitement 16 est propre à extraire les informations pertinentes des radiocommunications reçues par l'antenne 12. Pour cela, l'entrée 16E de l'unité de traitement 16 est reliée à l'antenne 12.

L'amplificateur 18 comporte une entrée 18E et une sortie 18S. L'amplificateur 18 est propre à amplifier l'amplitude d'une onde en entrée 18E. L'amplificateur 18 émet l'onde amplifiée sur la sortie 18S de l'amplificateur 18.

L'amplificateur 18 est souvent qualifié d'amplificateur 18 de puissance parce que l'amplificateur 18 augmente très fortement l'amplitude de l'onde en entrée 18E. L'amplitude de l'onde obtenue en sortie de l'amplificateur 18 présente une puissance de l'ordre de plusieurs centaines de Watts.

Plus précisément, dans le cas représenté, l'entrée 18E de l'amplificateur 18 est reliée à la sortie 16S de l'unité de traitement 16. L'amplificateur 18 amplifie le signal émis par l'unité de traitement 16.

Selon l'exemple de la figure 1, l'amplificateur 18 présente une impédance de 50 Ohms.

Le filtre 20 est relié à l'antenne 12. En l'occurrence, le filtre 20 est relié à l'antenne 12 par une liaison filaire.

Avantageusement, la distance entre l'antenne 12 et le filtre 20 est supérieure ou égale à 100 cm.

Le filtre 20 est également relié à l'amplificateur 18. En l'occurrence, le filtre 20 est relié à l'amplificateur 18 par une liaison filaire.

De préférence, la distance entre l'amplificateur 18 et le filtre 20 est inférieure ou égale à 1 cm.

Le filtre 20 est ainsi positionné entre l'amplificateur 18 et l'antenne 12.

Le filtre 20 est propre à assurer une fonction de filtrage d'harmoniques entre l'amplificateur 18 et le filtre 20. Autrement formulé, le filtre 20 est un filtre 20 « anti-harmonique ». A titre d'exemple, si f0 est la fréquence de fonctionnement, le filtre 20 est propre à filtrer les harmoniques dont la fréquence est comprise entre 2*f0 et 10*f0.

De préférence, le filtre 20 est un filtre 20 passe-bas.

Le filtre 20 présente une impédance variable.

Pour cela, le filtre 20 comprend au moins un composant électronique de valeur variable.

Dans ce contexte, une valeur variable correspond à une grandeur électrique. Par exemple, le composant électronique est un condensateur dont la capacité est variable, un potentiomètre ou une bobine 24 dont l'inductance est variable.

Selon l'exemple de la figure 1, le filtre 20 est un circuit LC.

Un circuit LC est un circuit électrique comprenant au moins un dipôle générateur d'impédance inductive et au moins un dipôle générateur d'impédance capacitive.

A titre d'exemple, le dipôle générateur d'impédance inductive est une bobine 24. Une bobine 24, solénoïde, auto-inductance ou quelquefois self (par anglicisme), est un composant courant en électrotechnique et électronique. Une bobine 24 est constituée d'un enroulement de fil conducteur éventuellement autour d'un noyau en matériau ferromagnétique qui peut être un assemblage de feuilles de tôle ou un bloc de ferrite (céramique ferromagnétique). Les physiciens et ingénieurs français l'appellent souvent par synecdoque « inductance », ce terme désignant la propriété caractéristique de la bobine 24, qui est son opposition à la variation du courant dans ses spires.

Selon un autre exemple, le dipôle générateur d'impédance inductive est une ligne quart d'onde, c'est-à-dire un morceau de ligne de transmission dont la longueur d'onde est égale au quart de la longueur d'onde du signal transporté sur la ligne quart d'onde considéré.

Dans le cas particulier de la figure 1, le circuit LC comporte une entrée 20E et une sortie 20S, l'entrée 20E étant reliée à la sortie 18S de l'amplificateur 18 et la sortie 20S du circuit LC étant reliée à l'antenne 12.

Le circuit LC comporte également une bobine 24 d'inductance variable reliant l'entrée 20E du circuit LC à la sortie 20S du circuit LC.

Le circuit LC comprend également un premier condensateur 26 de capacité variable reliant l'entrée 20E du circuit LC à la masse.

Le circuit LC comporte aussi un deuxième condensateur 28 reliant la sortie 20S du circuit LC à la masse.

L'organe de contrôle 22 de l'impédance du filtre 20 est propre à contrôler l'impédance du filtre 20 en fonction de l'impédance mesurée par le capteur.

Dans le cas représenté à la figure 1, l'organe de contrôle 22 est propre à contrôler l'impédance du filtre 20 pour que l'impédance du filtre 20 soit égale à l'impédance conjuguée de l'impédance mesurée par le capteur à 10% près du module de l'impédance du filtre 20.

En mathématiques, le conjugué d'un nombre complexe est le nombre complexe formé de la même partie réelle que mais de partie imaginaire opposée.

Pour contrôler l'impédance du filtre 20, l'organe de contrôle 22 est propre à modifier les valeurs de la bobine 24 et des condensateurs 26 et 28.

Le fonctionnement du poste de radiocommunication 10 est maintenant décrit en référence à un procédé d'adaptation d'impédance appliqué au poste de radiocommunication 10.

Le procédé d'adaptation d'impédance comporte une étape de mesure de l'impédance de l'antenne 12.

L'étape de mesure de l'impédance est mise en œuvre à l'aide du capteur de mesure d'impédance 14.

A l'issue de l'étape de mesure, l'organe de contrôle 22 reçoit un signal délivré par le capteur de mesure de l'impédance.

Le procédé d'adaptation d'impédance comprend également une étape de contrôle de l'impédance du filtre 20 en fonction de l'impédance mesurée à l'étape de mesure.

Pour cela, l'organe de contrôle 22 impose que l'impédance du filtre 20 soit égale à l'impédance mesurée à 10% près du module de l'impédance du filtre 20.

Du fait de la reconfigurabilité de l'impédance du filtre 20, le procédé d'adaptation est, de préférence, réitéré autant que souhaité. C'est ce qu'indique la flèche sur la figure 2.

A titre d'exemple, le procédé d'adaptation est mis en œuvre à intervalle temporel régulier.

Par exemple, l'intervalle entre deux adaptations est inférieur ou égal à 1 microseconde.

Ainsi, lorsque l'impédance de l'antenne 12 est loin de 50 Ohms, le filtre 20 est une cellule d'adaptation de l'impédance de l'antenne 12 avec l'impédance de l'amplificateur 18. Un gain de 20% à 30% en terme de puissance sur l'ensemble du poste est obtenu. L'adaptation est efficace pour des taux d'ondes stationnaires pouvant aller jusqu'à 5.

L'organe de contrôle 22 permet donc de contrôler l'impédance du filtre 20 pour adapter l'impédance de l'antenne 12 à l'impédance de l'amplificateur 18.

Le poste de radiocommunication 10 permet ainsi de garantir les performances de l'antenne 12 utilisée en large bande. De telles performances s'expriment notamment en terme de linéarité, de rendement ou de puissance. Le poste de radiocommunication 10 présente ainsi un meilleur rendement.

Le poste assure également une protection de l'amplificateur 18.

Le poste proposé est compact puisque le poste présente un encombrement réduit. En effet, le filtre 20 est un composant unique remplissant deux fonctions que sont le filtrage et l'adaptation d'impédance.

Le poste présente aussi l'avantage d'être relativement peu onéreux à fabriquer. En effet, seuls des composants électroniques disponibles dans le commerce sont utilisées, et ce sans un réglage spécifique.

Le poste de radiocommunication 10 s'applique dans de multiples domaines. Ainsi, il est proposé un dispositif comprenant un poste de radiocommunication 10 tel que précédemment décrit. Le dispositif est typiquement un équipement électronique de puissance. Par exemple, le dispositif est un téléphone portable.

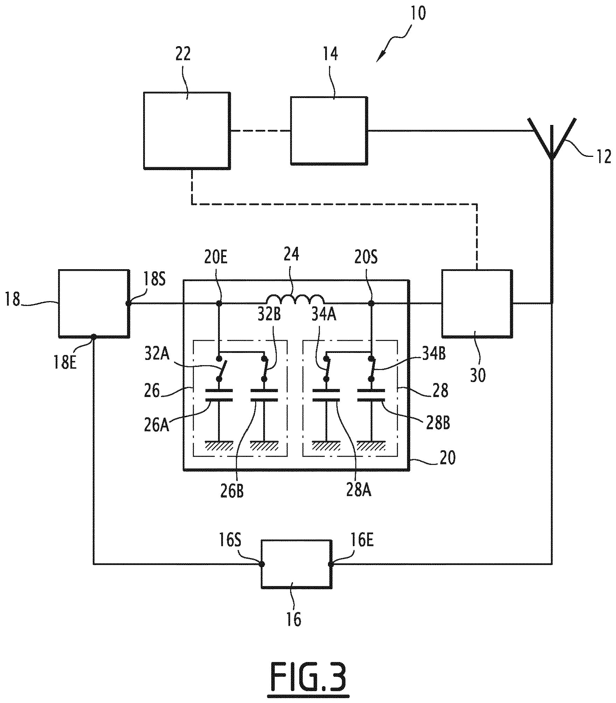

Un autre mode de réalisation du poste de radiocommunication 10 est illustré à la figure 3.

Le poste de radiocommunication 10 comporte les mêmes éléments que le poste de radiocommunication 10 décrit en référence à la figure 1. Les remarques concernant les éléments de la figure 1 qui s'appliquent également aux éléments de la figure 3 ne sont pas répétées dans la suite. Seules les différences sont détaillées dans ce qui suit.

Selon l'exemple de la figure 3, le poste de radiocommunication 10 comporte un deuxième capteur de mesure. Le deuxième capteur de mesure est un capteur de mesure de puissance 30 propre à mesurer la puissance réfléchie par le filtre 20.

Dans le cas de la figure 3, l'organe de contrôle 22 est propre à contrôler l'impédance du filtre 20 en fonction de deux mesures. Les deux mesures sont d'une part l'impédance de l'antenne 12 et d'autre part la puissance réfléchie par le filtre 20.

Selon un mode de réalisation, l'organe de contrôle 22 est propre à contrôler l'impédance du filtre 20 pour que la puissance réfléchie par le filtre 20 soit minimisée.

Par exemple, l'organe de contrôle 22 est propre à contrôler l'impédance du filtre 20 pour que la puissance réfléchie par le filtre 20 soit inférieure à -15 dB.

Selon l'exemple de la figure 3, le premier condensateur 26 comporte une première pluralité de condensateurs de capacité fixe reliés chacun à un interrupteur commandé respectif. Dans le cas de la figure 3, le premier condensateur 26 comporte un condensateur 26A et un condensateur 26B. Chaque condensateur 26A et 26B est respectivement associé à un interrupteur 32A et 32B, l'interrupteur 32A étant ouvert alors que l'interrupteur 32B est fermé.

Préférentiellement, chaque condensateur de la première pluralité de condensateurs comporte une capacité fixe distincte. La première pluralité des condensateurs forme ainsi une boîte à poids.

De préférence, le nombre de condensateurs de capacité fixe est compris entre huit et seize. Cela signifie que, d'une part, le nombre de condensateurs est supérieur ou égal à huit et, d'autre part, que le nombre de condensateurs est inférieur ou égal à seize.

L'organe de contrôle 22 est propre à commander chaque interrupteur.

A titre d'exemple, l'organe de contrôle 22 comporte un ensemble de diodes, chaque diode permettant de commander un interrupteur. Chaque diode est ainsi associée à un composant respectif. Plus précisément, chaque diode est associée à une capacité donnée.

Selon un mode de réalisation, chaque diode est alimentée par une source de tension continue.

Selon un mode de réalisation, chaque diode est une diode de puissance.de 500 V à 1000 V pouvant travailler jusqu'à des puissances de quelques centaines de watt.

Avantageusement, chaque diode est une diode PIN.

Une diode PIN (Positive Intrinsic Negative diode en anglais) est une diode constituée d'une zone non-dopée, dite intrinsèque I, intercalée entre deux zones dopées P et N. Une diode PIN polarisée dans le sens direct (passante) offre une impédance dynamique (vis-à-vis des signaux variables) extrêmement faible. Polarisée dans le sens inverse (bloquée) elle offre une très grande impédance et surtout une très faible capacité (elle se comporte comme un condensateur de très faible valeur, quelques picofarads, voire bien moins encore suivant les modèles).

De même, le deuxième condensateur 28 comporte une pluralité de condensateurs de valeur fixe reliés chacun à un interrupteur commandé respectif. L'organe de contrôle 22 est propre à commander chaque interrupteur. Dans le cas de la figure 3, le premier condensateur 28 comporte un condensateur 28A et un condensateur 28B. Chaque condensateur 28A et 28B est respectivement associé à un interrupteur 34A et 34B, chacun des deux interrupteurs 34A, 34B étant fermé.

Le fonctionnement ainsi que les avantages du poste de radiocommunication 10 selon la figure 3 est similaire à ceux décrits en référence à l'exemple de poste de radiocommunication 10 décrit en référence à la figure 1. Ils ne sont donc pas décrits davantage ici.

Chaque mode de réalisation décrit est combinable avec un autre mode de réalisation décrit pour donner un autre mode de réalisation lorsque cela est techniquement possible.

Notamment, selon un mode de réalisation, d'autres composants électroniques que des condensateurs comprennent une première pluralité de condensateurs de capacité fixe reliés chacun à un interrupteur commandé respectif.

Selon un autre mode de réalisation, le filtre 20 comporte une pluralité de circuit LC en série. Par exemple, le filtre 20 comporte une pluralité de circuit LC similaire à la figure 1 en série. Dans un tel cas, chaque sortie d'un circuit LC est soit relié à l'entrée du circuit LC suivant soit à l'antenne 12 (cas du dernier circuit LC lorsque le filtre 20 est parcouru depuis l'entrée vers la sortie).

En outre, selon une variante préférée, l'organe de contrôle 22 de l'impédance du filtre 20 contrôle l'impédance du filtre 20 pour que l'impédance de l'antenne 12 soit l'impédance optimale de l'amplificateur 18. Il est à noter que l'impédance optimale de l'amplificateur 18 est, dans certains cas, différente de 50 Ohms.

Le capteur de mesure d'impédance 14 permet de mesurer directement l'impédance de l'antenne 13. Ainsi, l'adaptation d'impédance du filtre 20 est basée sur une impédance d'antenne mesurée et non une impédance calculée. Il en résulte une meilleure adaptation de l'antenne 13.

## Revendications

1. Poste de radiocommunication (10) comprenant :
- une antenne (12) présentant une impédance,
- un capteur de mesure d'impédance (14) propre à mesurer l'impédance de l'antenne (12) pour obtenir une impédance mesurée,
- un amplificateur (18),
- un filtre (20) relié à l'antenne (12) et à l'amplificateur (18), le filtre (20) étant propre à assurer une fonction de filtrage d'harmoniques entre l'amplificateur (18) et l'antenne (12), le filtre (20) ayant une impédance variable, le filtre (20) étant un circuit LC, le circuit LC comportant une entrée (20E) et une sortie (20S), un élément générant une impédance inductive (24) reliant l'entrée (20E) à la sortie (20S) et un premier condensateur (26) reliant l'entrée (20E) à une masse et un deuxième condensateur (28) reliant la sortie (20S) à la masse, le premier condensateur (26) comportant une première pluralité de condensateurs (26A, 26B) de valeur fixe reliés chacun à un interrupteur (32A, 32B) commandé respectif, le deuxième condensateur (28) comportant une deuxième pluralité de condensateurs (28A, 28B) de valeur fixe reliés chacun à un interrupteur (34A, 34B) commandé respectif,
- un capteur de mesure de puissance, le capteur de mesure de puissance étant propre à mesurer la puissance réfléchie par le filtre (20) pour obtenir une puissance réfléchie mesurée, et
- un organe de contrôle (22) de l'impédance du filtre (20), l'organe étant propre à contrôler l'impédance du filtre (20) en fonction de l'impédance mesurée, l'organe de contrôle (22) étant propre à contrôler l'impédance du filtre (20) également en fonction de la puissance réfléchie mesurée, l'organe de contrôle (22) étant également propre à commander chaque interrupteur (32A, 32A, 34A, 34B).

2. Poste selon la revendication 1, dans lequel l'élément générant une impédance inductive (24) comprend une bobine, une bobine d'inductance variable ou une ligne quart d'onde.

3. Poste selon la revendication 1 ou 2, dans lequel l'organe de contrôle (22) est propre à contrôler l'impédance du filtre (20) pour que l'impédance du filtre (20) soit égale à l'impédance conjuguée de l'impédance mesurée à 10% près du module de l'impédance mesurée.

4. Poste selon l'une quelconque des revendications 1 à 3, dans lequel l'organe de contrôle (22) est propre à contrôler l'impédance du filtre (20) à intervalle de temps régulier.

5. Dispositif, notamment téléphone portable, comportant un poste (10) selon l'une quelconque des revendications 1 à 4.

6. Procédé d'adaptation d'impédance dans un poste de radiocommunication (10) comprenant :
- une antenne (12) présentant une impédance,
- un capteur de mesure d'impédance (14),
- un capteur de mesure de puissance,
- un amplificateur (18),
- un filtre (20) relié à l'antenne (12) et à l'amplificateur (18), le filtre (20) étant propre à assurer une fonction de filtrage d'harmoniques entre l'amplificateur (18) et l'antenne (12), le filtre (20) ayant une impédance variable, le filtre (20) étant un circuit LC, le circuit LC comportant une entrée (20E) et une sortie (20S), un élément générant une impédance inductive (24) reliant l'entrée (20E) à la sortie (20S) et un premier condensateur (26) reliant l'entrée (20E) à une masse et un deuxième condensateur (28) reliant la sortie (20S) à la masse, le premier condensateur (26) comportant une première pluralité de condensateurs (26A, 26B) de valeur fixe reliés chacun à un interrupteur (32A, 32B) commandé respectif, le deuxième condensateur (28) comportant une deuxième pluralité de condensateurs (28A, 28B) de valeur fixe reliés chacun à un interrupteur (34A, 34B) commandé respectif, et
- un organe de contrôle (22) de l'impédance du filtre (20), le procédé d'adaptation comportant les étapes de :
- mesure de l'impédance de l'antenne (12) par le capteur de mesure d'impédance (14) pour obtenir une impédance mesurée,
- mesure, par le capteur de mesure de puissance, de la puissance réfléchie par le filtre (20) pour obtenir une puissance réfléchie mesurée, et
- contrôle de l'impédance du filtre (20) en fonction de l'impédance mesurée et en fonction de la puissance réfléchie mesurée, le contrôle de l'impédance du filtre (20) comprenant la commande de chaque interrupteur (32A, 32A, 34A, 34B) par l'organe de contrôle (22).

## Patentansprüche

1. Funkkommunikationsstation (10), umfassend:
- eine Antenne (12), die eine Impedanz aufweist,
- einen Impedanzmesssensor (14), der geeignet ist, um die Impedanz der Antenne (12) zu messen, um eine gemessene Impedanz zu erlangen,
- einen Verstärker (18),
- einen Filter (20), der mit der Antenne (12) und dem Verstärker (18) verbunden ist, wobei der Filter (20) geeignet ist, um eine Filterfunktion von Oberwellen zwischen dem Verstärker (18) und der Antenne (12) zu gewährleisten, wobei der Filter (20) eine variable Impedanz aufweist, wobei der Filter (20) eine LC-Schaltung ist, die LC-Schaltung umfassend einen Eingang (20E) und einen Ausgang (20S), ein eine induktive Impedanz erzeugendes Element (24), das den Eingang (20E) mit dem Ausgang (20S) verbindet, und einen ersten Kondensator (26), der den Eingang (20E) mit einer Masse verbindet, und einen zweiten Kondensator (28), der den Ausgang (20S) mit der Masse verbindet, der erste Kondensator (26) umfassend eine erste Vielzahl von Kondensatoren (26A, 26B) mit festem Wert, die jeweils mit einem jeweiligen gesteuerten Schalter (32A, 32B) verbunden sind, der zweite Kondensator (28) umfassend eine zweite Vielzahl von Kondensatoren (28A, 28B) mit festem Wert, die jeweils mit einem jeweiligen gesteuerten Schalter (34A, 34B) verbunden sind,
- einen Leistungsmesssensor, wobei der Leistungsmesssensor geeignet ist, um die von dem Filter (20) reflektierte Leistung zu messen, um eine gemessene reflektierte Leistung zu erlangen, und
- ein Steuerorgan (22) der Impedanz des Filters (20), wobei das Organ geeignet ist, um die Impedanz des Filters (20) abhängig von der gemessenen Impedanz zu steuern, wobei das Steuerorgan (22) geeignet ist, um die Impedanz des Filters (20) auch abhängig von der gemessenen reflektierten Leistung zu steuern, wobei das Steuerorgan (22) auch geeignet ist, um jeden Schalter (32A, 32A, 34A, 34B) zu steuern.

2. Station nach Anspruch 1, wobei das induktive Impedanz erzeugende Element (24) eine F-Spule, eine Spule variabler Induktivität oder eine Viertelwellenleitung umfasst.

3. Station nach Anspruch 1 oder 2, wobei das Steuerorgan (22) geeignet ist, um die Impedanz des Filters (20) zu steuern, sodass die Impedanz des Filters (20) gleich wie die konjugierte Impedanz der gemessenen Impedanz innerhalb von 10 % des Moduls der gemessenen Impedanz ist.

4. Station nach einem der Ansprüche 1 bis 3, wobei das Steuerorgan (22) geeignet ist, um die Impedanz des Filters (20) in regelmäßigen Zeitabständen zu steuern.

5. Vorrichtung, insbesondere Mobiltelefon, umfassend eine Station (10) nach einem der Ansprüche 1 bis 4.

6. Verfahren zur Anpassung der Impedanz in einer Funkkommunikationsstation (10), umfassend:
- eine Antenne (12), die eine Impedanz aufweist,
- einen Impedanzmesssensor (14),
- einen Leistungsmesssensor,
- einen Verstärker (18),
- einen Filter (20), der mit der Antenne (12) und dem Verstärker (18) verbunden ist, wobei der Filter (20) geeignet ist, um eine Filterfunktion von Oberwellen zwischen dem Verstärker (18) und der Antenne (12) zu gewährleisten, wobei der Filter (20) eine variable Impedanz aufweist, wobei der Filter (20) eine LC-Schaltung ist, die LC-Schaltung umfassend einen Eingang (20E) und einen Ausgang (20S), ein eine induktive Impedanz erzeugendes Element (24), das den Eingang (20E) mit dem Ausgang (20S) verbindet, und einen ersten Kondensator (26), der den Eingang (20E) mit einer Masse verbindet, und einen zweiten Kondensator (28), der den Ausgang (20S) mit der Masse verbindet, der erste Kondensator (26) umfassend eine erste Vielzahl von Kondensatoren (26A, 26B) mit festem Wert, die jeweils mit einem jeweiligen gesteuerten Schalter (32A, 32B) verbunden sind, der zweite Kondensator (28) umfassend eine zweite Vielzahl von Kondensatoren (28A, 28B) mit festem Wert, die jeweils mit einem jeweiligen gesteuerten Schalter (34A, 34B) verbunden sind, und
- ein Steuerorgan (22) für die Impedanz des Filters (20), das Anpassungsverfahren umfassend die folgenden Schritte:
- Messen der Impedanz der Antenne (12) durch den Impedanzmesssensor (14), um eine gemessene Impedanz zu erlangen,
- Messen der von dem Filter (20) reflektierten Leistung durch den Leistungsmesssensor, um eine gemessene reflektierte Leistung zu erlangen, und
- Steuern der Impedanz des Filters (20) in Abhängigkeit von der gemessenen Impedanz und in Abhängigkeit von der gemessenen reflektierten Leistung, das Steuern der Impedanz des Filters (20) umfassend das Steuern von jedem Schalter (32A, 32A, 34A, 34B) durch das Steuerorgan (22).

## Claims

1. Radio communication set (10) comprising:
- an antenna (12) with an impedance,
- an impedance measurement sensor (14) suitable for measuring the impedance of the antenna (12) to obtain a measured impedance,
- an amplifier (18),
- a filter (20) connected to the antenna (12) and to the amplifier (18), the filter (20) being adapted to provide a harmonic filtering function between the amplifier (18) and the antenna (12), the filter (20) having a variable impedance, the filter (20) being an LC circuit, the LC circuit having an input (20E) and an output (20S) an inductive impedance generating element (24) connecting the input (20E) to the output (20S) and a first capacitor (26) connecting the input (20E) to ground and a second capacitor (28) connecting the output (20S) to ground, the first capacitor (26) including a first plurality of fixed value capacitors (26A, 26B) each connected to a respective controlled switch (32A, 32B), the second capacitor (28) including a second plurality of fixed value capacitors (28A, 28B) each connected to a respective controlled switch (34A, 34B),
- a power measurement sensor, the power measurement sensor being adapted to measure the power reflected from the filter (20) to obtain a measured reflected power, and
- a controller (22) for controlling the impedance of the filter (20), the controller being adapted to control the impedance of the filter (20) as a function of the measured impedance, the controller (22) being adapted to control the impedance of the filter (20) also as a function of the measured reflected power, the controller (22) being also adapted to control each switch (32A, 32A, 34A, 34B).

2. The station of claim 1, wherein the inductive impedance generating element (24) comprises an F coil, a variable inductance coil or a quarter wave line.

3. A station according to claim 1 or 2, wherein the controller (22) is adapted to control the impedance of the filter (20) so that the impedance of the filter (20) is equal to the conjugate impedance of the measured impedance within 10% of the modulus of the measured impedance.

4. A station according to any one of claims 1 to 3, wherein the controller (22) is adapted to control the impedance of the filter (20) at regular time intervals.

5. Device, in particular a cell phone, comprising a station (10) according to any of claims 1 to 4.

6. A method of impedance matching in a radio station (10) comprising:
- an antenna (12) with an impedance,
- an impedance measurement sensor (14),
- a power measurement sensor,
- an amplifier (18),
- a filter (20) connected to the antenna (12) and to the amplifier (18), the filter (20) being suitable for providing a harmonic filtering function between the amplifier (18) and the antenna (12), the filter (20) having a variable impedance, the filter (20) being an LC circuit the LC circuit having an input (20E) and an output (20S), an inductive impedance generating element (24) connecting the input (20E) to the output (20S) and a first capacitor (26) connecting the input (20E) to ground and a second capacitor (28) connecting the output (20S) to ground the first capacitor (26) including a first plurality of fixed value capacitors (26A, 26B) each connected to a respective controlled switch (32A, 32B), the second capacitor (28) including a second plurality of fixed value capacitors (28A, 28B) each connected to a respective controlled switch (34A, 34B), and
- a controller (22) for monitoring the impedance of the filter (20), the matching method comprising the steps of:
- measuring the impedance of the antenna (12) by the impedance measurement sensor (14) to obtain a measured impedance,
- measurement by the power measurement sensor of the power reflected by the filter (20) to obtain a measured reflected power, and
- controlling the impedance of the filter (20) as a function of the measured impedance and as a function of the measured reflected power, the controlling of the impedance of the filter (20) comprising controlling each switch (32A, 32A, 34A, 34B) by the controller (22).
